# EUROPEAN PATENT APPLICATION

(11) **EP 1 372 187 A1**
(43) Date of publication of application: **17.12.2003**
(21) Application number: 03012838.3
(22) Date of filing: 06.06.2003
(51) Int. Cl.: H01L 21/02

(54) **Method for manufacturing semiconductor device**

(30) Priority: 10.06.2002 JP 2002169141
(71) Applicant: MATSUSHITA ELECTRIC INDUSTRIAL CO., LTD., Kadoma-shi, Osaka (JP)
(72) Inventor: Shinya, Natsume, Takatsuki-shi, Osaka 569-1143 (JP); Takumi, Mikawa, Otsu-shi, Shiga 520-2101 (JP); Yuuji, Juudai, Uji-shi, Kyoto 611-0002 (JP)
(74) Representative: Stippl, Hubert, Dipl.-Ing.

(57) **Abstract**

A method for manufacturing a semiconductor device includes forming an insulating film (107) so as to cover a patterned film (106) including a noble metal, and polishing the insulating film (107) by a chemical-mechanical polishing process at a pressure from 34.5 x 10³Pa to 48.3 x 10³Pa without exposing the surface of the patterned film, and then polishing at a pressure from 6.9 x 10³Pa to 20.7 x 10³Pa so as to expose the patterned film. Thus, it is possible to bury the film including a noble metal without the generation of scratches, deformation and peeling of the film including a noble metal and without a film that remains on the film including a noble metal.

## Description

The present invention relates to a method for manufacturing a semiconductor device. In particular, it relates to a method for burying a film including a noble metal in an insulating film.

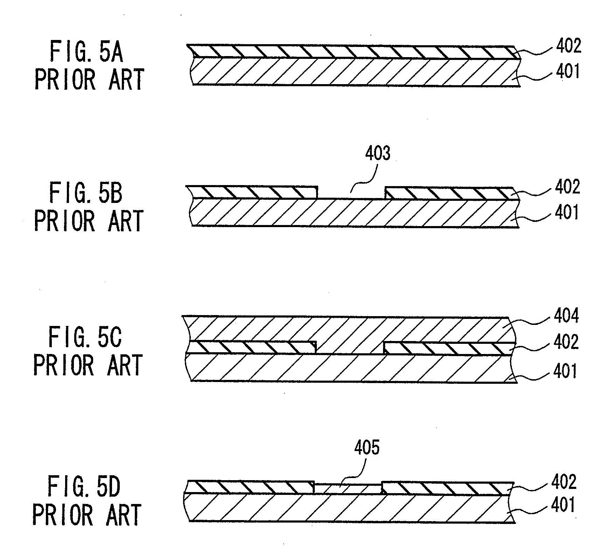

A first conventional method for burying a metal film of a semiconductor device will be explained with reference to cross-sectional views of a process sequence shown in Figures 5A to 5D.

As shown in Figure 5A, an insulating film 402 is formed on a semiconductor substrate 401. Subsequently, as shown in Figure 5B, a resist pattern (not illustrated) is formed on a predetermined position of the insulating film 402. By using this resist pattern as a mask, a hole 403 is formed in the insulating film 402 by dry etching. Then, on the entire surface, thereof, as shown in Figure 5C, a metal film 404 is formed by a sputtering method, a CVD method, or a plating method. Then, as shown in Figure 5D, by using slurry for a metal film (slurry containing a chemical liquid such as an oxidizing agent that embrittles a metal film), a metal film is polished by a chemical-mechanical polishing process (also referred to as "CMP process," hereinafter) process until the upper surface of the insulating film is exposed.

According to the processes mentioned above, the metal film 405 is buried in the insulating film 402 until the upper surface of the insulating film 402 reaches a height identical with that of the upper surface of the metal film 405.

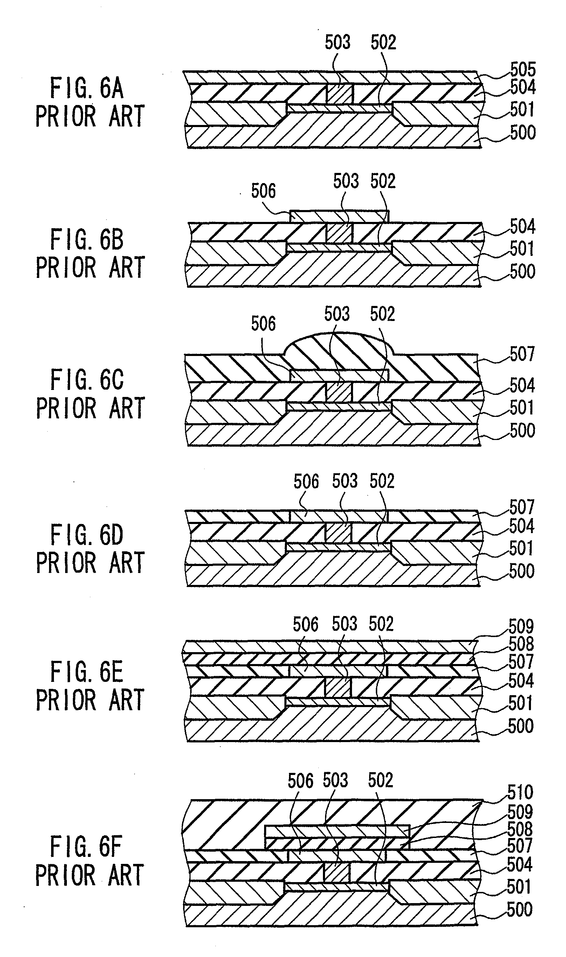

Next, a second conventional method described in JP2000-138349A will be explained with reference to cross-sectional views of a process sequence shown in Figures 6A to 6F. In this example, a buried electrode film is used as a lower electrode of a capacitor. First, as shown in Figure 6A, on a semiconductor substrate 500 provided with an STI (shallow trench isolation) separation region 501 covered with an interlayer insulating film 504, a high concentration impurity diffusion layer 502 and a contact plug 503, an electrode material 505 (for example, a laminated layer of a titanium nitride barrier layer and a platinum film) is formed on the entire surface. Subsequently, as shown in Figure 6B, an electrode material 505 is patterned by using a desired mask (not illustrated) so that the contact plug 503 is covered to form a lower electrode 506. Then, on the entire surface, thereof, as shown in Figure 6C, an insulating film 507 to be buried is formed. Then, as shown in Figure 6D, for the purpose of reducing step heights and flattening the surface, the insulating film 507 is polished until the surface of the lower electrode is exposed. Next, as shown in Figure 6E, on the entire surface of the laminate shown in Figure 6D, a dielectric film 508 is formed and a second conductive film 509 is formed further thereon. Subsequently, as shown in Figure 6F, the second conductive film 509 and the dielectric film 508 are patterned by using a desired mask (not illustrated) so that the lower electrode is covered to form a capacitance insulating film and an upper electrode. Herein, both the capacitance insulating film and the upper electrode are patterned at the same time, but they may be patterned separately. Furthermore, a capacitance interlayer insulating film 510 is coated thereon.

By using the above-mentioned structure, since the insulating film can be formed on the lower electrode having a flat surface with no unevenness as the underlying layer, the film quality of the insulating film is satisfactory.

In particular, if a noble metal is used for a lower electrode, since a noble metal film is chemically stable in general, it is possible to provide the effect for forming a stable lower electrode in which elements constituting a dielectric substance can be prevented from diffusing at the time of sintering at a high temperature for crystallizing the dielectric substance, the reduction of the polarization amount can be suppressed and the reliability of the dielectric substance can be maintained.

In the above-mentioned first conventional method, when a metal film is polished, a slurry developed for polishing the metal film is used. In general, when a hard metal is polished, it is necessary to polish by using a chemical reaction. As to a slurry for polishing a copper (Cu) film or a tungsten (W) film widely used for a wiring, a plug, etc., slurries have been developed, respectively. For example, as to a tungsten (W) film, tungsten is oxidized and embrittled by an oxidizing agent such as H₂O₂, (Fe(NO₃)₃), KIO₃, or the like, which are contained in the slurry, then the oxidized and embrittled film is polished by a mechanical action. Furthermore, as to a copper (Cu) film, the surface of the copper film embrittled with an oxidizing agent is mechanically polished with an abrasive agent.

However, as to a slurry for a noble metal film, at the present time, the development has just started. Furthermore, a noble metal is a material that is not likely to be chemically reacted, thus making it difficult to develop slurries capable of using chemical reaction with the use of oxidization agents, etc. Therefore, at the present time, there is no effective method for carrying out a CMP process with respect to a noble metal.

When a noble metal film is polished with general slurry for a metal film (slurry containing a chemical liquid such as an oxidizing agent for allowing a metal film to be chemically reacted), the mechanical action is greater than the chemical action, and thus scratches occur more easily. Furthermore, even if a noble metal film is to be polished with slurry for an insulating film (slurry which does not contain a chemical liquid capable of embrittling a metal film and which is an alkaline or neutral slurry using alumina, silica, and cerium oxide as an abrasive grain), most of the noble metal film is not polished. Furthermore, if the polishing pressure is increased, scratches occur easily. Furthermore, also as to a plating method for burying a noble metal film in a hole, development has not been satisfactory.

Furthermore, in the second conventional method, a specific problem that occurs when the uppermost layer of the lower electrode material is made of a noble metal film will be explained. In the second conventional method, the insulating film on the lower electrode material is polished and the surface of the lower electrode material is polished. However, for example, when the lower electrode material is a metal other than an oxidizing film or a noble metal film, as mentioned above, since it is possible to carry out polishing with the chemical effect along with the mechanical effect, the occurrence of scratches can be suppressed. However, in the case where the uppermost layer of the lower electrode material is a noble metal film, when the noble metal film is exposed, the chemical effect cannot be used and thus the mechanical pressure is applied strongly. Furthermore, since a noble metal generally has high ductility, scratches occur.

In the above-mentioned conventional example, a noble metal film was described. However, also in a film including a noble metal, for example, an oxide film of a noble metal, the similar problem occurs.

With the foregoing in mind, it is an object of the present invention to provide a method for manufacturing a semiconductor device capable of burying a film including a noble metal while reducing the generation of scratches, deformation and peeling of the film including a noble metal, and furthermore avoiding a film remaining on the film including a noble metal.

In order to achieve the above-mentioned object, the method for manufacturing a semiconductor device according to the present invention includes, forming an insulating film so as to cover a patterned film including a noble metal, and polishing the insulating film by a chemical-mechanical polishing process.
Figures 1A to 1F are cross-sectional views showing a process sequence of a manufacturing method in a first embodiment of the present invention.
Figures 2A to 2D are cross-sectional views showing a process sequence of a manufacturing method in a second embodiment of the present invention.
Figures 3A to 3C are cross-sectional views showing a process sequence of a manufacturing method in a second embodiment of the present invention.
Figure 4 is a graph showing the relationship between a polishing pressure and the number of defects in one embodiment of the present invention.
Figures 5A to 5D are cross-sectional views showing a process sequence of a manufacturing method in a first conventional example.
Figures 6A to 6F are cross-sectional views showing a process sequence of a manufacturing method in a second conventional example.

The preferable method for manufacturing a semiconductor device of the present invention includes forming a conductive film including a noble metal on a semiconductor substrate, patterning a predetermined region of the conductive film by etching to form a film including a noble metal, forming an insulating film so as to cover the film including a noble metal, and flattening the insulating film by a chemical-mechanical polishing process so as to expose the surface of the film including a noble metal. According to this method, it is possible to bury the film including a noble metal without leaving the electric insulating film remaining on the film including a noble metal. In the above, it is desirable that a flattening is a state in which variation in height of the surface of the insulating film is 30 nm or less. The method for measuring thereof is carried out by using a step height measurement device such as an optical film thickness measurement device or an atomic force microscope (AFM), etc. Furthermore, a flattening means the extent in which defects caused by the shape are not generated within the range of the depth of focus (DOF) of the lithography in the downstream operation.

Furthermore, another preferable method of manufacturing a semiconductor device of the present invention includes forming a conductive film including a film including a noble metal on a semiconductor substrate, patterning a predetermined region of the conductive film by etching to form a film including a noble metal, forming an insulating film so as to cover the a film including a noble metal, flattening the insulating film without exposing the surface of the film including a noble metal by a first chemical-mechanical polishing at a relatively high polishing pressure, and polishing the insulating film remaining on the surface of the film including a noble metal so as to expose the surface of the film including a noble metal by a second chemical-mechanical polishing at a relatively low polishing pressure. According to this method, the process time can be shortened and scratches can be reduced.

Furthermore, according to a further preferable method of manufacturing a semiconductor device of the present invention includes forming a conductive film made of a noble metal on a semiconductor substrate, patterning a predetermined region of the conductive film by etching to form a film including a noble metal, forming an insulating film so as to cover the film including a noble metal, flattening the insulating film by a chemical-mechanical polishing process without exposing the surface of the film including a noble metal, and etching the insulating film remaining on the surface of the film including a noble metal so as to expose the surface of the film including a noble metal. According to this method, scratches generated when the film including a noble metal is polished, deformation and peeling of the film including a noble metal can be prevented.

In the method for manufacturing the semiconductor device of the present invention, it is preferable that the polishing pressure of the chemical-mechanical polishing process is in the range from 6.9 × 10³ Pa to 20.7 × 10³ Pa. Thus, it is possible to reduce the peeling of the film or the generation of scratches of the film including a noble metal and to reduce the number of defects.

In the method for manufacturing the semiconductor device of the present invention, it is preferable that the polishing pressure of the first chemical mechanical polishing is in the range from 34.5 × 10³ Pa to 48.3 × 10³ Pa, and the polishing pressure of the second chemical-mechanical polishing is in the range from 6.9 × 10³ Pa to 20.7 × 10³ Pa. By carrying out the above-mentioned two stage polishing steps, two effects can be obtained, that is, the process time can be shortened and scratches can be reduced.

In the method for manufacturing the semiconductor device of the present invention, it is preferable that the insulating film is etched by wet etching. Thus, even if a recess or deformation etc., is present in the film including a noble metal, the electric insulating film can be removed perfectly.

In the method for manufacturing the semiconductor device of the present invention, it is preferable that the insulating film is etched by dry etching. Thus, it is possible to prevent the expansion of scratches generated when wet etching is used.

In the method for manufacturing the semiconductor device of the present invention, the film including a noble metal is at least one film selected from the group consisting of a film of platinum (Pt), iridium (Ir), ruthenium (Ru), gold (Au), silver (Ag), palladium (Pd), a film of an alloy thereof, and a film of oxide thereof. In particular, it is preferable that a platinum film is used for the film including a noble metal, because platinum is the most chemically stable among noble metals. It is possible to form a conductive film with high reliability and to reduce scratches.

According to this embodiment, it is possible to bury a film including a noble metal in which scratches, and deformation and peeling of a film including a noble metal are not generated and further no film remains on the film including a noble metal. Thus, the reliability of the high density packaging semiconductor device can be improved and the yield in manufacturing can be improved.

Hereinafter, the present invention will be explained by way of embodiments.

### (First Embodiment)

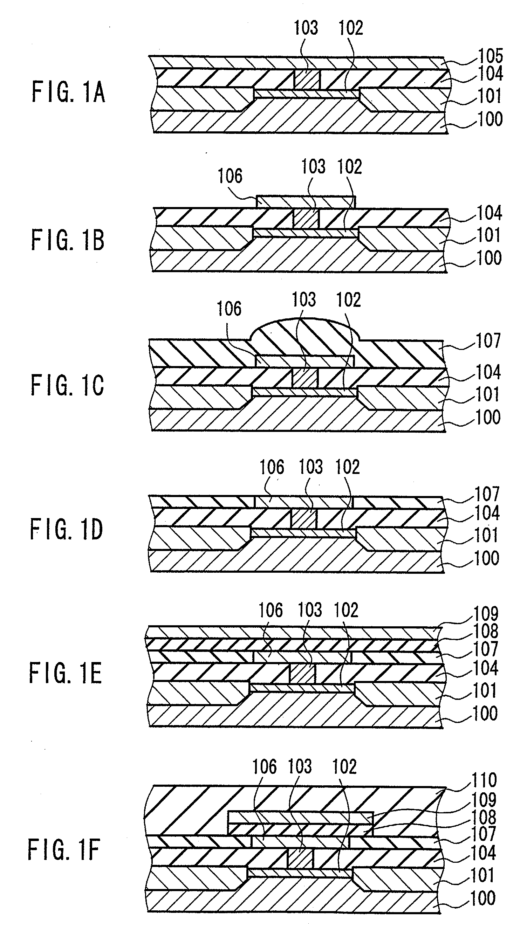

The first embodiment of the present invention will be explained with reference to cross-sectional views showing a process sequence of Figures 1A to 1F. Figures 1A to 1F shows an example in which a film including a noble metal buried in an insulating film is used for a lower electrode of a capacitance element such as an FeRAM (ferroelectric random access memory) or a DRAM (dynamic random access memory). Herein, the reason why the lower electrode is buried in the insulating film after patterning is mentioned below. If the lower electrode, the dielectric substance and the upper electrode are dry-etched continuously, the dielectric substance is damaged at the time of dry etching. Further, if the lower electrode is patterned first, the upper electrode can be connected to a bit line in the vertical direction, so that the upper electrode itself can be made a wire.

As shown in Figure 1A, a semiconductor substrate 100 is provided with a STI separation region 101 covered with a 0.5 µm thick interlayer insulating film 104 made of a BPSG (boro-phosphosilicate glass) film, a high concentration impurity diffusing layer 102 and a contact plug 103 (the contact plug is made of, for example, a metal such as tungsten, molybdenum, titanium, titanium nitride, tantalum nitride and metal silicide, and the metal silicide includes Ti, Ni, or Co, Cu or doped polycrystalline silicon) formed in the interlayer insulating film 104. A film 105 including a noble metal (for example, Pt, Ir, Ru film, or an alloy film containing thereof, or oxide thereof) is formed thereon preferably to the thickness of 10 to 100 nm by a sputtering method or a CVD method.

Under the film 105 including a noble metal, a conductive film may be formed as a barrier with respect to oxidation of the contact plug in the thermal hysteresis at the time of sintering a high-dielectric substance. An example of this conductive barrier film includes a film partially including TiAlN or at least either Ti or Al, or a film partially including a noble metal, or a laminated film thereof. The film thickness is preferably in the range from 10-200 nm.

Next, as shown in Figure 1B, patterning was carried out by using a desired mask (not illustrated) so that the contact plug 103 is covered to thus form a lower electrode 106. Subsequently, as shown in Figure 1C, an insulating film 107 to be buried was formed on the entire surface of the semiconductor substrate by a sputtering method or by a CVD method. As a material of the insulating film 107, O₃-TEOS (tetraethoxysilane) was used. The film thickness of the insulating film 107 was 0.45 µm.

Then, as shown in Figure 1D, step heights were reduced and the surface was flattened by a chemical-mechanical polishing (CMP) process to expose the surface of the lower electrode. Apolishing slurry used at this time was a general slurry for an insulating film, which is an alkaline or neutral slurry containing polishing particles of alumina, silica, cerium oxide, etc. However, the slurry is not limited to this, and any slurry for a metal film may be used as long as the polishing can be carried out at the rate with respect to an insulating film of 50 nm/min or more. At this time, the uppermost layer of the lower electrode is a film including a noble metal and the selective ratio of the polishing is large and it functions as a polishing stopper. Variation in height of the surface of the insulating film is preferably 30 nm or less.

Next, as shown in Figure 1E, a dielectric film 108 (for example, perovskite type composite oxide such as PZT (lead zirconate tintanete), BST (barium titanate strontium), SBT (strontium bismuth tantalium), etc.) was formed by spin coating or by a CVD method. Furthermore, a second conductive film 109 (a film including a noble metal, or a film of an alloy thereof, or an oxide film of a noble metal film, or a nitride film of a noble metal) was formed to the thickness of 0.05 µm by a sputtering method or by a CVD method. Subsequently, as shown in Figure 1F, patterning was carried out by using a desired mask (not illustrated) so that the lower electrode was covered to form a capacitance insulating film and an upper electrode. Furthermore, the capacitor was coated with a 0.5 µm thick interlayer insulating film 110 made of a BPSG film.

Herein, the capacitance insulating film and the upper electrode were patterned at the same time, but they may be patterned separately. Furthermore, herein, the case where the film including a noble metal was used for the lower electrode of the capacitance element was explained as an example. However, the noble metal film is not limited to this use as a lower electrode, and the film including a noble metal buried in the insulating film can be used for, for example, a contact plug, or a wiring, etc.

Furthermore, in this embodiment, at the time of a CMP process for exposing a film including a noble metal, in order to prevent the insulating film from being left non-polished on the a film including a noble metal all over the entire surface of the wafer and to expose the surface of the film including a noble metal uniformly, it is necessary to polish more sufficiently of a portion corresponding to variations generated by the difference in the in-plane uniformity of the polishing amount and the difference in the property for reducing step heights by patterning or an over-etched amount in the dry etching for forming the step heights, etc. at the time of etching. As a result, polishing proceeds even after the surface of the film including a noble metal is exposed and flattened. In the slurry for insulating film, since the polishing rate of the insulating film is faster than that in the a film including a noble metal, recesses are generated around the step height, and the step height of the film including a noble metal tends to have a convex shape. In the case where the step height portion has a convex shape in this way, the polishing pressure is likely to be concentrated therein.

Furthermore, in general, in polishing a metal film, polishing is carried out by embrittling the metal film by a chemical effect (for example, oxidation reaction by H₂O₂) with chemicals, etc. contained in slurry for a metal film along with the mechanical effect. On the other hand, in slurry for an insulating film, chemicals causing a chemical reaction are not contained and a film including a noble metal is polished by being affected by a mechanical effect rather than the chemical reaction. Due to the above-mentioned polishing with concentrated pressure and strong mechanical effect, scratches easily occur on the film including a noble metal. Furthermore, some films including a noble metal have great ductility, so that the film including a noble metal is stretched by the pressure to be torn.

Furthermore, there also is a problem that if a recess becomes larger, the lower electrode or the uppermost layer of the film including a noble metal itself is peeled off due to the polishing pressure. Particles, which cause the generation of new scratches together with particles from the torn film including a noble metal, are generated. As a result, scratches are generated not only on the conductive film but also on the insulating film. The above-mentioned scratches, deformation, tear and recess not only affect the stability or reliability of the semiconductor element but also cause the occurrence of defects.

Furthermore, unless polishing is carried out sufficiently, the insulating film may remain on the surface of a conductive film. Thus, when the buried film including a noble metal is used as the dielectric lower electrode of DRAM or FeRAM, the area of the electrode is reduced, or the growth of the dielectric film on the remaining film may be prevented.

In general, in polishing an insulating film, a mechanical effect mainly acts on. Therefore, the polishing pressure is such as high as in the range from 34.5 × 10³ Pa to 48.3 × 10³ Pa and the concentration of slurry grains is also high, and thus scratches are generated easily when a film including a noble metal is exposed.

Therefore, in this embodiment, when the insulating film is polished at such a low polishing pressure as in the range from 6.9 × 10³ Pa to 20.7 × 10³ Pa, peeling or the generation of scratches in the film including a noble metal can be reduced and the number of defects can be reduced.

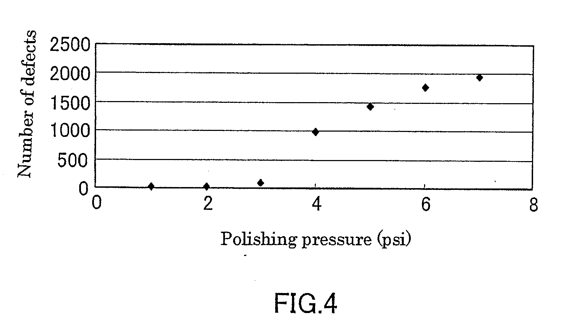

Figure 4 is a graph showing the relationship between the polishing pressure and the number of defects. This graph shows that by polishing the insulating film at a low pressure of 6.9 × 10³ Pa to 20.7 × 10³ Pa, polishing can be carried out with the number of defects greatly reduced.

However, when the polishing pressure is small, the polishing rate also is slow. Therefore, by carrying out two stages of polishing steps, in which, the polishing is carried out at the polishing pressure of 4.5 × 10³ Pa to 48.3 × 10³ Pa (at the polishing rate of more than 50 nm/min or more) in the range before the surface of the a film including a noble metal is exposed, and then the polishing is carried out at the polishing pressure of 6.9 × 10³ Pa to 20.7 × 10³ Pa so as to expose the surface of the film including a noble metal, two effects can be obtained. That is, the process time can be shortened and scratches can be reduced.

### (Second Embodiment)

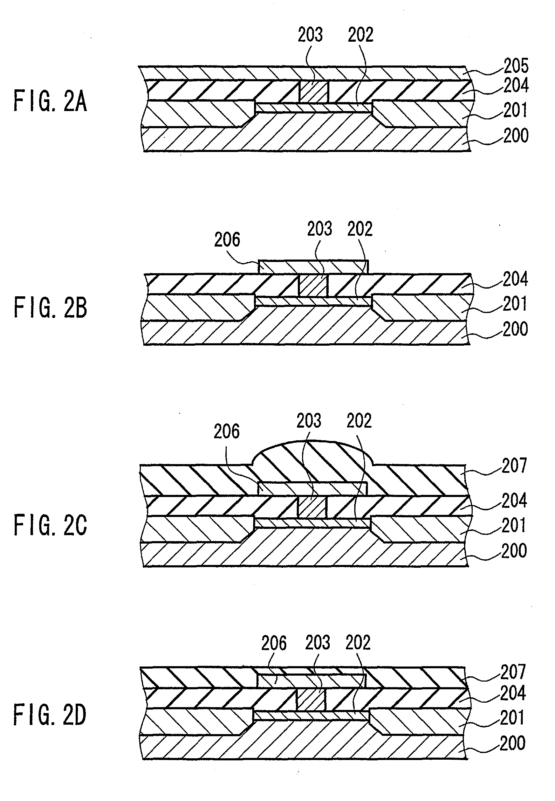

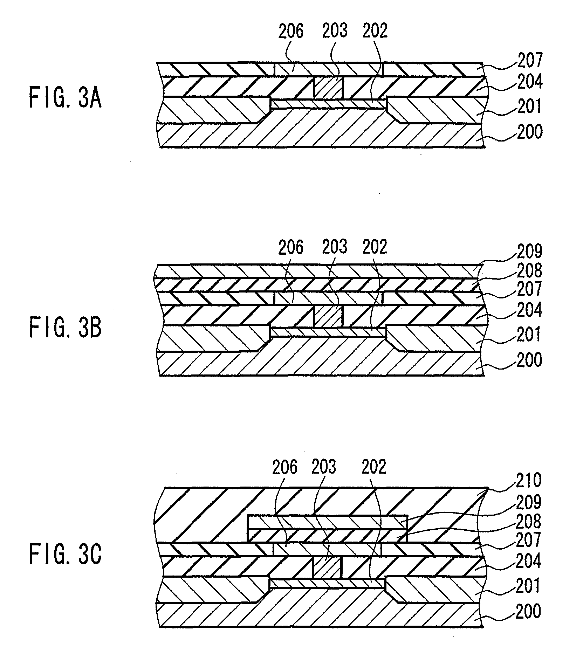

The method for manufacturing a semiconductor device according to a second embodiment of the present invention will be explained with reference to the cross-sectional views showing process sequence shown of Figure 2 and Figure 3.

The processes shown in Figures 2A to 2C are the same as those shown in Figures 1A to 1C. Therefore, the explanation therefor will be omitted herein.

Next, as shown in Figure 2D, within the range in which a film including a noble metal is not exposed, step heights were reduced and the surface was flattened by a CMP process. The polished slurry used at this time was general slurry containing polishing particles of alumina, silica, cerium oxide, etc.

Subsequently, as shown in Figure 3A, an insulating film 207 was removed uniformly by etching until the surface of a film including a noble metal 206 was exposed.

Herein, in the case where a contact plug 203 is made of, for example, tungsten (W), when the contact plug was buried by W-CVD and a CMP process was carried out, a recess was generated. If a film for a lower electrode was formed on the recess, a dent due to the recess was reprinted on the film including a noble metal that was the uppermost layer of the electrode.

In general, since a wafer is polished by a flat surface plate in a CMP process, it is not easy to remove the film attached on the dent. Therefore, it is necessary to carry out an extra over-polishing. The carrying out the over-polishing may increase the problem such as the generation of scratches as mentioned above.

Therefore, in the embodiment, if wet etching is employed for etching, it is possible to perfectly remove the insulating film that cannot easily be removed by a CMP process when a recess or deformation, etc. is present in the film including a noble metal. Furthermore, in wet etching, it is possible to vary the selective ratio of the film including a noble metal to the insulating film. Under the condition where the film including a noble metal is not wet-etched, it is possible to suppress the variation in the film thickness of the film including a noble metal. For example, when the buried film including a noble metal is used for, for example, as a wiring, the effect in which the variation in wiring resistance can be resolved perfectly.

Furthermore, in this embodiment, dry etching also can be employed as the etching. Herein, the case where the etching is carried out by dry etching will be explained specifically.

First of all, as shown in Figure 2D, in the first stage of the CMP process, polishing is carried out so that the film thickness of the insulating film on the a film including a noble metal becomes, for example, 0 to 150 nm. At this time, in order to prevent peeling of the film including a noble metal, it is preferable that the film including a noble metal is not exposed on any portions in the surface of the wafer. Subsequently, as shown in Figure 3A, the insulating film is etched by dry etching by using, for example, a gas such as CHF₃/O₂ or CF₄/O₂ at the pressure of 6 to 8 Pa so that all the electrodes on the wafer are exposed. At this time, by bringing the selective ratio of the dry etching close to 1, it is possible to eliminate a recess generated on the film including a noble metal and the insulating film. Furthermore, if the selective ratio of the dry etching is increased, the film including a noble metal can be exposed from the insulating film. Next, in order to remove deposited materials generated in dry etching, for example, low-temperature ashing by using O₂ is carried out. Next, in order to remove particles mainly produced by dry etching, washing is carried out by using, for example, a chemical solution such as DIW or NH₄0H or HF or an organic solvent. At this time, megasonic (ultrasonic) washing or brush washing may be carried out at the same time.

When dry etching is carried out, micro scratches generated at the time of the CMP process, which may be generated in the case where the wet etching is carried out, can be eliminated.

In general, it is impossible to perfectly remove micro-scratches generated by a CMP process. Fine micro-scratches that may not reduce the yield of the device are not insignificant. However, by adding wet etching, such insignificant micro-scratches are expanded isotropically, which may lead to a reduction in the yield. For example, with respect to a micro scratch having a width of 10 nm, when wet etching corresponding to the size of 100 nm is added, the micro scratches having a width of 210 nm are generated. Furthermore, in the film damaged by the micro scratches, the wet etching rate is faster and the depth of scratches becomes expanded.

Therefore, as mentioned above, it is desirable that dry etching is carried out as the etching, particularly, isotropic dry etching is used. By this method, the effect of preventing scratches from expanding at the time of the CMP process and not reducing the final yield is achieved.

In this manufacturing method, since the film including a noble metal is not exposed at the time of the CMP process, it is possible to prevent scratches generated when a film including a noble metal is polished, or deformation or peeling of the film including a noble metal explained in the first Embodiment.

Next, with respect to Figures 3B and 3C, the same process treatments as those in Figures 1E and 1F are carried out.

Thus, it is possible to form a capacitance element having a high reliability in which fewer scratches are generated and variation in the dielectric property is not observed.

Furthermore, in the embodiment, in the case where the film including a noble metal is made of platinum, since platinum is the most chemically stable among noble metals (platinum is dissolved only in the aqua regia and is unaffected by any simple strong acids and alkalines. However, it is affected by dissolved alkalines, basic water and bromine water), the mechanical effect works at the time of polishing, and at the same time, the adhesiveness with respect to the other films is deteriorated. Consequently, the film is likely to be peeled off. If the film is peeled off, such a peeled film is formed into scratches. The present invention is particularly effective in eliminating such scratches.

## Claims

1. A method for manufacturing a semiconductor device comprising:
forming an insulating film so as to cover a patterned film including a noble metal; and
polishing the insulating film by a chemical-mechanical polishing process.

2. The method for manufacturing a semiconductor device according to claim 1, wherein the patterned film including a noble metal is formed by etching a predetermined region of the film including a noble metal formed on a substrate of the semiconductor.

3. The method for manufacturing a semiconductor device according to claim 1, wherein the polishing pressure of the chemical-mechanical polishing process is in the range from 6.9 × 10³ Pa to 20.7 × 10³ Pa.

4. The method for manufacturing a semiconductor device according to claim 1, wherein the insulating film is flattened by a chemical-mechanical polishing process until the surface of the film including a noble metal is exposed.

5. The method for manufacturing a semiconductor device according to claim 4, wherein the chemical-mechanical polishing process comprises a first chemical-mechanical polishing for flattening the insulating film without exposing the surface of the a film including a noble metal at a relatively high polishing pressure; and a second chemical-mechanical polishing for polishing the insulating film remaining on the surface of the film including a noble metal so as to expose the surface of the film including a noble metal at a relatively low polishing pressure.

6. The method for manufacturing a semiconductor device according to claim 5, wherein the polishing pressure of the first chemical mechanical polishing is in the range from 34.5 × 10³ Pa to 48.3 × 10³ Pa, and the polishing pressure of the second chemical-mechanical polishing is in the range from 6.9 × 10³ Pa to 20.7 × 10³ Pa.

7. The method for manufacturing a semiconductor device according to claim 1, wherein the chemical-mechanical polishing process is carried out until the insulating film is flattened without exposing the surface of the film including a noble metal, and the insulating film remaining on the surface of the film including a noble metal is further etched so as to expose the surface of the film including a noble metal .

8. The method for manufacturing a semiconductor device according to claim 7, wherein the insulating film is etched by wet etching.

9. The method for manufacturing a semiconductor device according to claim 7, wherein the insulating film is etched by dry etching.

10. The method for manufacturing a semiconductor device according to claim 1, wherein the film including a noble metal is at least one film selected from the group consisting of a platinum (Pt) film, an iridium (Ir) film, a ruthenium (Ru) film, gold (Au), silver (Ag), palladium (Pd), a film of an alloy thereof, and a film of oxide thereof.

11. The method for manufacturing a semiconductor device according to claim 10, wherein the film including a noble metal is a platinum film.

12. The method for manufacturing a semiconductor device according to claim 1, wherein the chemical-mechanical polishing process uses an alkaline or neutral polishing slurry comprising polishing particles of alumina, silica, or cerium oxide.

13. The method for manufacturing a semiconductor device according to claim 1, wherein the chemical-mechanical polishing process is carried out at the polishing rate with respect to the insulating film of 50 nm/min or more.
